# EUROPÄISCHE PATENTSCHRIFT

(11) **EP 1 374 353 B1**
(45) Veröffentlichungstag und Bekanntmachung des Hinweises auf die Patenterteilung: **21.09.2016**
(21) Anmeldenummer: 01997871.7
(22) Anmeldetag: 20.11.2001
(51) Int. Cl.: H01S 5/00

(54) **ÜBEREINANDER GESTAPELTE HALBLEITER-DIODENLASER**
STACKED SEMICONDUCTOR LASER DIODE
LASERS A DIODE A SEMI-CONDUCTEURS EMPILES LES UNS SUR LES AUTRES

(30) Priorität: 21.11.2000 DE 10057698
(43) Veröffentlichungstag der Anmeldung: 02.01.2004
(60) Teilanmeldung: 16182390.1
(73) Patentinhaber: OSRAM Opto Semiconductors GmbH, 93055 Regensburg (DE)
(72) Erfinder: BEHRINGER, Martin, 93051 Regensburg (DE); EBELING, Karl, 89075 Ulm (DE); KNÖDL, Thomas, 88094 Oberteuringen (DE); LUFT, Johann, 93195 Wolfsegg (DE)
(74) Vertreter: Epping - Hermann - Fischer
(86) Internationale Anmeldenummer: PCT/DE2001/004350
(87) Internationale Veröffentlichungsnummer: WO 2002/043204

(56) Entgegenhaltungen:
- EP-A- 0 803 948
- US-A- 5 212 706
- US-A- 5 679 963
- US-A- 5 679 963
- US-A- 6 133 590
- JAIN F ET AL: "MONOLITHIC INTEGRATION OF RED, BLUE AND GREEN LASERS FOR SMART PROJECTION DISPLAYS" 1995 SID INTERNATIONAL SYMPOSIUM DIGEST OF TECHNICAL PAPERS. ORLANDO, MAY 23 - 25, 1995, SID INTERNATIONAL SYMPOSIUM DIGEST OF TECHNICAL PAPERS, SANTA ANA, SID, US, Bd. 26, 23. Mai 1995 (1995-05-23), Seiten 516-519, XP000657166 ISSN: 0097-966X
- KIM J K ET AL: "NEAR-ROOM-TEMPERATURE CONTINUOUS-WAVE OPERATION OF MULTIPLE-ACTIVE-REGION 1.55 MUM VERTICAL-CAVITY LASERS WITH HIGH DIFFERENTIAL EFFICIENCY" APPLIED PHYSICS LETTERS, AMERICAN INSTITUTE OF PHYSICS. NEW YORK, US, Bd. 77, Nr. 20, 13. November 2000 (2000-11-13), Seiten 3137-3139, XP000970279 ISSN: 0003-6951
- PATENT ABSTRACTS OF JAPAN vol. 1996, no. 09, 30. September 1996 (1996-09-30) & JP 08 139404 A (NEC CORP), 31. Mai 1996 (1996-05-31)

## Beschreibung

Die vorliegende Erfindung betrifft übereinander gestapelte Halbleiter-Diodenlaser.

Hochleistungs-Diodenlaser, die eine hohe Leistung emittieren, belasten die Facetten der einzelnen Kristallschichten bis in den Grenzbereich. Um die erreichbare Leistung eines Diodenlasers zu erhöhen, können zwei Diodenlaser monolithisch übereinander integriert werden. Dazu werden entsprechende Schichten übereinandergewachsen. Der Kontakt zwischen zwei übereinander gewachsenen Diodenlasern wird, wie in dem Patent US 5,212,706 beschrieben, beispielsweise durch eine hoch dotierte Tunneldiode erreicht, die in Sperrrichtung gepolt ist. Die Tunneldiode ist extremen Belastungen in Bezug auf die durch sie fließende Stromstärke ausgesetzt und kann durch die vorherrschenden Belastungen zerstört werden. Ein weiteres Beispiel für einen Tunnelkontakt ist in dem Patent US 5,679,963 angegeben.

JAIN F ET AL: "MONOLITHIC INTEGRATION OF RED, BLUE AND GREEN LASERS FOR SMART PROJECTION DISPLAYS", 1995 SID INTERNATIONAL SYMPOSIUM DIGEST OF TECHNICAL PAPERS. ORLANDO, MAY 23 - 25, 1995, SID INTERNATIONAL SYMPOSIUM DIGEST OF TECHNICAL PAPERS, SANTA ANA, SID, US, Bd. 26, 23. Mai 1995 (1995-05-23), Seiten 516-519, offenbart eine Anordnung übereinander gestapelter Halbleiter-Diodenlaser mit einen Tunnelkontaktschicht umfassend zwei leitfähige Schichten und zwei dotierte Zwischenschichten.

Die Laserdioden werden üblicherweise aus einer Reihe von Schichten aufgewachsen, wobei die einzelnen Schichten unterschiedliche Materialien und folglich unterschiedliche Gitterkonstanten aufweisen können. Die unterschiedlichen Gitterkonstanten zwischen benachbarten Schichten führen zu Verspannungen, so daß in dem Schichtstapel elastische Energie gespeichert wird und Kräfte zwischen benachbarten Schichten wirken. Ist die zwischen zwei Schichten wirkende Kraft zu groß, so entstehen Gitterversetzungen in oder zwischen den entsprechenden Schichten, wodurch die Diodenlaser unbrauchbar werden können.

Es ist die Aufgabe der Erfindung, einen verbesserten Kontakt zwischen zwei übereinander angeordneten Diodenlasern anzugeben.

Erfindungsgemäß wird die gestellte Aufgabe durch eine Anordnung übereinander gestapelter Halbleiter-Diodenlaser gelöst mit:
- einem Substrat, auf dem ein erster Diodenlaser angeordnet ist;
- einem zweiten Diodenlaser, der auf dem ersten Diodenlaser angeordnet ist;
- einer Kontaktschicht, die zwischen dem ersten Diodenlaser und dem zweiten Diodenlaser angeordnet ist, wobei die Kontaktschicht eine erste leitfähige Schicht eines ersten Leitungstyps, eine zweite leitfähige Schicht eines zweiten Leitungstyps und eine Zwischenschicht umfaßt, wobei die Zwischenschicht zwischen der ersten und der zweiten leitfähigen Schicht angeordnet ist und die Tunnelwahrscheinlichkeit für Ladungsträger erhöht, wobei die Zwischenschicht undotiert ist oder mit dem ersten Leitungstyp dotiert ist, jedoch eine niedrigere Dotierstoffkonzentration aufweist als die erste leitfähige Schicht des ersten Leitungstyps.

Die erfindungsgemäße Zwischenschicht weist den Vorteil auf, daß die Ladungsträger-Absorption und die Streuung an ionisierten Störstellen in ihr reduziert ist, so daß die Ladungsträger höhere Lebensdauern aufweisen und somit der elektrische Widerstand vermindert ist. Der verminderte elektrische Widerstand führt dazu, daß der leitfähige Kontakt auch bei extremen Strombelastungen stabil bleibt und nicht zerstört wird. Dadurch wird die Lebensdauer der Diodenlaser-Anordnung in vorteilhafter Weise verlängert.

In einer Ausgestaltung der Erfindung ist vorgesehen, daß die Zwischenschicht undotiert ist. Eine undotierte (intrinsische) Schicht hat den Vorteil, daß die Ladungsträger-Absorption und die Streuung von Ladungsträgern an ionisierten Störstellen im unmittelbaren Übergangsbereich reduziert ist. Dadurch besitzen die Ladungsträger eine erhöhte Lebensdauer, so daß der elektrische Widerstand der leitfähigen Kontaktschicht reduziert ist. In vorteilhafter Weise wird die Zwischenschicht relativ dünn ausgebildet. Sie kann eine Dicke zwischen einer Monolage und 50 nm aufweisen.

Eine weitere erfindungsgemäße Anordnung sieht vor, daß die Zwischenschicht mit dem ersten oder dem zweiten Leitungstyp dotiert ist, jedoch eine niedrigere Dotierstoffkonzentration aufweist, als die erste oder die zweite leitfähige Schicht.

Die erfindungsgemäße Aufgabe wird ebenfalls gelöst durch eine Anordnung übereinander gestapelter Halbleiter-Diodenlaser mit:
- einem Substrat, auf dem ein erster Diodenlaser angeordnet ist;
- einem zweiten Diodenlaser, der auf dem ersten Diodenlaser angeordnet ist;
- einer Kontaktschicht, die zwischen dem ersten Diodenlaser und dem zweiten Diodenlaser angeordnet ist, wobei die Kontaktschicht eine erste leitfähige Schicht eines ersten Leitungstyps, eine zweite leitfähige Schicht eines zweiten Leitungstyps, eine erste Zwischenschicht und eine zweite Zwischenschicht aufweist, wobei die erste und die zweite Zwischenschicht zwischen der ersten und zweiten leitfähigen Schicht angeordnet sind, und die erste Zwischenschicht der ersten leitfähigen Schicht und die zweite Zwischenschicht der zweiten leitfähigen Schicht zugewandt ist, und die erste oder die zweite Zwischenschicht eine Dicke zwischen 4 und 12 nm aufweist.

Die erste und die zweite Zwischenschicht ermöglichen Quantenphänomene, da durch sie die Bandstruktur so modifiziert ist, daß Quantentrog-ähnliche Modifikationen des Ferminiveaus auftreten. Beispielsweise ist die effektiv erreichbare Dotierung in der ersten und zweiten Zwischenschicht gegenüber Bulk-Material erhöht. Durch die erhöhte effektive Dotierung ist beispielsweise die Ladungsträgerdichte ebenfalls erhöht, wodurch der elektrische Kontakt einen reduzierten Kontaktwiderstand aufweist.

Eine vorteilhafte Ausgestaltung der Erfindung sieht vor, daß die erste Zwischenschicht den gleichen Leitungstyp wie die erste leitfähige Schicht aufweist, jedoch eine höhere Dotierstoffkonzentration besitzt und die zweite Zwischenschicht den gleichen Leitungstyp wie die zweite leitfähige Schicht aufweist, jedoch eine höhere Dotierstoffkonzentration besitzt. Die erhöhte Dotierstoffkonzentration der ersten und zweiten Zwischenschicht ermöglicht es, eine erhöhte Ladungsträgerdichte gegenüber herkömmlichen pn-Tunnel-Kontakten zu erreichen, wodurch der Kontaktwiderstand des elektrischen Kontaktes reduziert ist.

Weiterhin ist vorgesehen, daß die erste und/oder die zweite Zwischenschicht eine Dicke zwischen einer Monolage und 30 nm, beziehungsweise zwischen 4 nm und 12 nm aufweist. Eine Dicke zwischen einer Monolage und 30 nm ermöglicht die Ausbildung von Quantentrog-ähnlichen Strukturen, wodurch Quantenphänomene ermöglicht werden, die eine erhöhte effektiv erreichbare Dotierung und damit eine erhöhte Ladungsträgerdichte gegenüber herkömmlichen Strukturen ermöglichen. Eine Dicke zwischen 4 und 12 nm ist in vorteilhafter Weise dazu geeignet, Quantentrog-ähnliche Strukturen auszubilden.

Nachfolgend wird die Erfindung anhand von Ausführungsbeispielen und Figuren näher erläutert. In den Figuren bezeichnen gleiche Bezugszeichen gleiche bzw. funktionsgleiche Elemente.

In den Figuren zeigen:
- Figur 1: eine schematische Darstellung eines Schnittes durch einen Chip mit einem Halbleiterkörper mit zwei übereinander gestapelten Halbleiter-Diodenlasern;
- Figur 2: eine weitere schematische Darstellung eines Schnittes durch einen Chip mit einem Halbleiterkörper mit zwei übereinander gestapelten Halbleiter-Diodenlasern;
- Figur 3: eine schematische Darstellung eines Schnittes durch eine erste erfindungsgemäße Ausgestaltung einer Kontaktschicht zwischen zwei übereinander gestapelten Halbleiter-Diodenlasern;
- Figur 4: eine schematische Darstellung eines Schnittes durch ein weiteres Ausführungsbeispiel einer erfindungsgemäßen Kontaktschicht zwischen zwei übereinander gestapelten Halbleiter-Diodenlasern.

Bei der Beschreibung der Ausführungsbeispiele ist jeweils ein entsprechendes komplementäres Ausführungsbeispiel mitumfaßt, bei dem sämtliche Dotierungen durch ihre komplementäre Dotierung ersetzt werden. Beispielsweise sind sämtliche p-Dotierungen durch n-Dotierungen zu ersetzen.

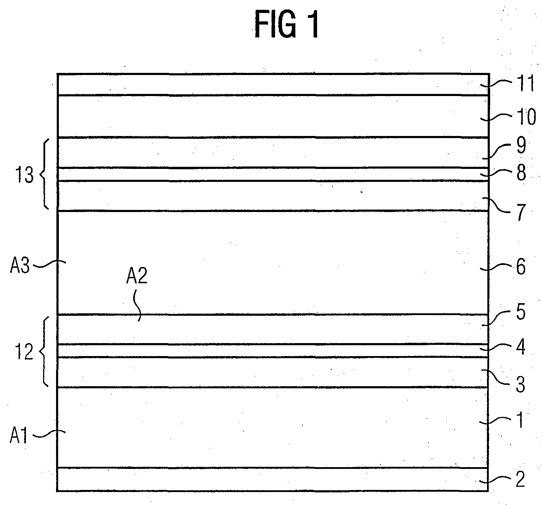

In Figur 1 ist ein Diodenlaser mit einem Substrat 1 dargestellt, welches mit einer ersten Kontaktierungsschicht 2 kontaktiert ist. Auf dem Substrat 1 ist auf einer der ersten Kontaktierungsschicht 2 abgewandten Oberfläche ein erster Diodenlaser 12 angeordnet. Dieser umfaßt beispielsweise eine erste Begrenzungsschicht 3 aus n-dotiertem Aluminiumgalliumarsenid (n-Al_{X}Ga₁₋ₓAs) und eine zweite Begrenzungsschicht 5 aus p-dotiertem Aluminiumgalliumarsenid (p-Al_{X}Ga₁₋ₓAs), zwischen denen eine erste aktive Laserschicht 4 angeordnet ist, die beispielsweise Galliumarsenid bzw. Indiumgalliumarsenid aufweist. Weiterhin kann die Laserschicht 4 mit p-Typ bzw. n-Typ Dotierstoff dotiert sein. Durch Wahl des Materials der Laserschicht 4 kann die Wellenlänge der emittierten Strahlung verändert werden. Ebenso sind Laser umfaßt, die aus anderen Materialsystemen mit beispielsweise Phosphiden oder Seleniden bestehen.

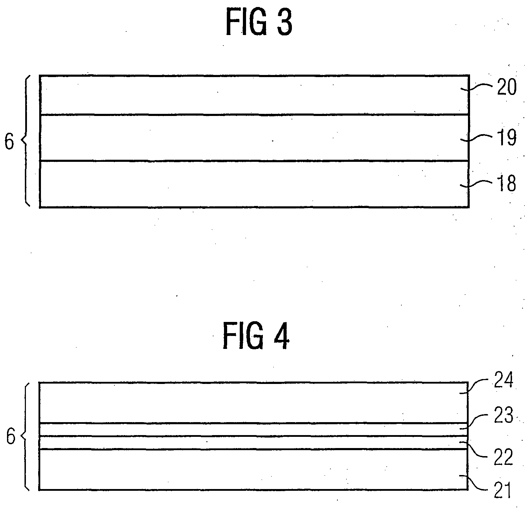

Auf der zweiten Begrenzungsschicht 5 ist eine Kontaktschicht 6 angeordnet. Die Kontaktschicht 6 wird in Zusammenhang mit Figur 3 und 4 näher erläutert. Auf der Kontaktschicht 6 ist ein zweiter Diodenlaser 13 angeordnet, der analog zu dem ersten Diodenlaser 12 aufgebaut ist und eine dritte Begrenzungsschicht 7 aus n-dotiertem Aluminiumgalliumarsenid (n-Al_{X}Ga₁₋ₓAs), eine zweite aktive Laserschicht 8 und eine vierte Begrenzungsschicht 9 aus p-dotiertem Aluminiumgalliumarsenid (p-Al_{X}Ga₁₋ₓAs) umfaßt. Auf dem zweiten Diodenlaser 13 ist eine Verbindungsschicht 10 und auf dieser eine zweite Kontaktierungsschicht 11 angeordnet.

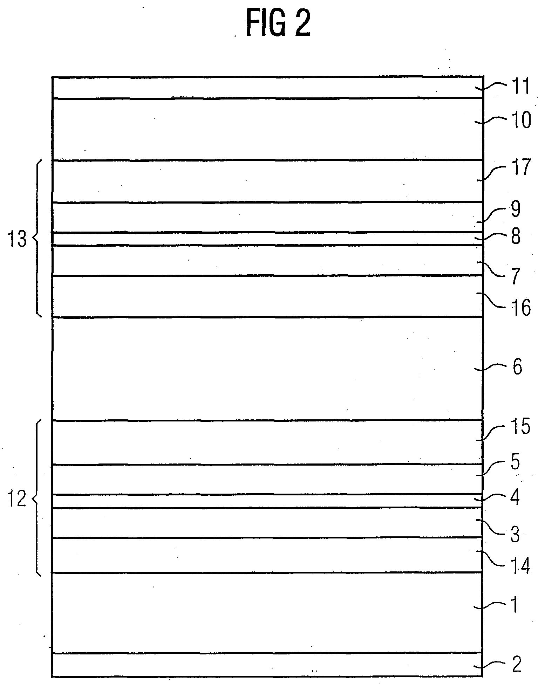

Bei dem in Figur 2 dargestellten Ausführungsbeispiel ist jeweils auf der von der aktiven Laserschicht 4, 8 abgewandten Seite der Begrenzungsschichten 3, 5, 7, 9 eine Mantelschicht 14, 15, 16, 17 angeordnet. Die Mantelschichten begünstigen die Wellenführung in den Diodenlasern 12, 13. Weiterhin kann eine Ladungsträgerinversion erleichtert werden, wodurch die Schwelle für den Laser reduziert wird.

Beispielsweise kann vorgesehen werden, daß die erste und zweite Mantelschicht 14, 15 einen Aluminiumanteil von etwa 30 % und die erste und zweite Begrenzungsschicht 3, 5 einen Aluminiumanteil von etwa 60 % aufweisen. Diese Ausgestaltung führt zu einer vorteilhaften Wellenführung in dem ersten Diodenlaser 12. Die dritte und vierte Mantelschicht 16, 17 weisen z.B. ebenfalls eine Aluminiumkonzentration von 30 % und die dritte und vierte Begrenzungsschicht 7 und 9 eine Aluminiumkonzentration von 60 % auf. Dies begünstigt die Wellenführung in dem zweiten Diodenlaser 13.

In Figur 3 ist die Kontaktschicht 6 dargestellt. Die Kontaktschicht 6 umfaßt eine erste leitfähige Schicht 18, die mit einem ersten Dotierstofftyp dotiert ist. Weiterhin umfaßt die Kontaktschicht 6 eine zweite leitfähige Schicht 20, die mit einem zweiten Dotierstofftyp dotiert ist. Der erste Dotierstofftyp ist dabei komplementär zu dem zweiten Dotierstofftyp gewählt. Weiterhin ist zwischen der ersten leitfähigen Schicht 18 und der zweiten leitfähigen Schicht 20 eine Zwischenschicht 19 angeordnet. In einem Ausführungsbeispiel ist die Zwischenschicht 19 beispielsweise undotiert, also intrinsisch. Dies hat den Vorteil, daß die Ladungsträger-Absorption und die Streuung von Ladungsträgern an ionisierten Störstellen im Übergangsbereich reduziert wird, da die Anzahl der Störstellen reduziert ist. Folglich ist der elektrische Widerstand der Kontaktschicht 6 reduziert.

Ein weiteres Ausführungsbeispiel sieht vor, daß die Zwischenschicht 19 mit dem ersten oder dem zweiten Ladungsträgertyp dotiert ist.

Hierbei wird die Dotierstoffkonzentration der Zwischenschicht 19 geringer gewählt als die Dotierstoffkonzentration der ersten leitfähigen Schicht 18 oder der zweiten leitfähigen Schicht 20.

Ein weiteres Ausführungsbeispiel der Kontaktschicht 6 ist in Figur 4 dargestellt. In diesem Fall umfaßt die Kontaktschicht 6 eine erste leitfähige Schicht 21, eine erste Zwischenschicht 22, die auf der leitfähigen Schicht 21 angeordnet ist, eine zweite Zwischenschicht 23, die auf der ersten Zwischenschicht 22 angeordnet ist und eine zweite leitfähige Schicht 24, die auf der zweiten Zwischenschicht 23 angeordnet ist. Beispielsweise handelt es sich bei der ersten leitfähigen Schicht 21 um eine p-dotierte Galliumarsenidschicht bzw. Aluminiumgalliumarsenidschicht. Weiterhin handelt es sich bei der ersten Zwischenschicht 22 um eine hoch-p-dotierte Galliumarsenidschicht und bei der zweiten Zwischenschicht 23 um eine hoch-n-dotierte Galliumarsenidschicht. Bei der zweiten leitfähigen Schicht 24 handelt es sich beispielsweise um eine n-dotierte Galliumarsenidschicht. Darüber hinaus sind folgende Materialien für die erste leitfähige Schicht 21, die erste Zwischenschicht 22, die zweite Zwischenschicht 23 und die zweite leitfähige Schicht 24 geeignet. Beispielsweise kann Indium-Gallium-Aluminium-Arsenid in der ersten leitfähigen Schicht 21, der ersten Zwischenschicht 22, der zweiten Zwischenschicht 23 und der zweiten leitfähigen Schicht 24 enthalten sein.

Wird die erste Zwischenschicht 22 und die zweite Zwischenschicht 23 mit einer Dicke zwischen einer Monolage und 50 nm - also beispielsweise 10 nm - gebildet, so bilden sich Quantentrog-ähnliche Strukturen (quantum well), die höher dotierbar sind, als Bulk-Material. Dadurch wird eine erhöhte Ladungsträgerdichte erreicht, die zu einer erhöhten Tunnelwahrscheinlichkeit und somit zu einem reduzierten Kontaktwiderstand führt.

Die Beschreibung des Ausführungsbeispiels ist nicht als Einschränkung auf Galliumarsenid zu verstehen. Die Schichtenfolge kann ebenso in entsprechender Weise durch Galliumnitrid, Zinkselenid oder Zinktellurid oder aus einer Verbindung gemäß der allgemeinen Formel (Zn,Mg,Cd)(S,Se,Te), wobei die Anteile der einzelnen Bestandteile auch gleich Null sein können, ersetzt werden.

## Patentansprüche

1. Anordnung übereinander gestapelter Halbleiter-Diodenlaser mit:
- einem Substrat (1), auf dem ein erster Diodenlaser (12) angeordnet ist;
- einem zweiten Diodenlaser (13), der auf dem ersten Diodenlaser (12) angeordnet ist;
- einer Kontaktschicht (6), die zwischen dem ersten Diodenlaser (12) und dem zweiten Diodenlaser (13) angeordnet ist, wobei
die Kontaktschicht (6) eine erste leitfähige Schicht (18) eines ersten Leitungstyps, eine zweite leitfähige Schicht (20) eines zweiten Leitungstyps aufweist und wobei die Kontaktschicht entweder
a) eine Zwischenschicht (19) umfaßt, die zwischen der ersten und zweiten leitfähigen Schicht (18, 20) angeordnet ist und die Tunnelwahrscheinlichkeit für Ladungsträger erhöht, wobei die Zwischenschicht (19) undotiert ist oder die Zwischenschicht (19) mit dem ersten Leitungstyp dotiert ist jedoch eine niedrigere Dotierstoffkonzentration aufweist als die erste leitfähige Schicht (18) des ersten Leitungstyps, oder
b) eine erste Zwischenschicht (22) und eine zweite Zwischenschicht (23) aufweist, wobei die erste und die zweite Zwischenschicht (22, 23) zwischen der ersten und zweiten leitfähigen Schicht (21, 24) angeordnet sind und die erste Zwischenschicht (22) der ersten leitfähigen Schicht (21) und die zweite Zwischenschicht (23) der zweiten leitfähigen Schicht (24) zugewandt ist, und wobei die erste oder die zweite Zwischenschicht (22, 23) eine Dicke zwischen 4 und 12 nm aufweist.

2. Anordnung nach Anspruch 1,
**dadurch gekennzeichnet, daß** in Variante b) die erste Zwischenschicht (22) den gleichen Leitungstyp wie die erste leitfähige Schicht (21) aufweist, jedoch eine höhere Dotierstoffkonzentration besitzt und die zweite Zwischenschicht (23) den gleichen Leitungstyp wie die zweite leitfähige Schicht (24) aufweist, jedoch eine höhere Dotierstoffkonzentration besitzt.

## Claims

1. Arrangement of semiconductor diode lasers stacked one above another comprising:
- a substrate (1), on which a first diode laser (12) is arranged;
- a second diode laser (13) arranged on the first diode laser (12); and
- a contact layer (6) arranged between the first diode laser (12) and the second diode laser (13), wherein the contact layer (6) comprises a first conductive layer (18) of a first conduction type, a second conductive layer (20) of a second conduction type, and wherein the contact layer either
a) comprises an intermediate layer (19) which is arranged between the first and second conductive layers (18, 20) and increases the tunnelling probability for charge carriers, wherein the intermediate layer (19) is undoped or the intermediate layer (19) is doped with the first conduction type but has a lower dopant concentration than the first conductive layer (18) of the first conduction type, or
b) comprises a first intermediate layer (22) and a second intermediate layer (23), wherein the first and second intermediate layers (22, 23) are arranged between the first and second conductive layers (21, 24) and the first intermediate layer (22) faces the first conductive layer (21) and the second intermediate layer (23) faces the second conductive layer (24), and wherein the first or the second intermediate layer (22, 23) has a thickness of between 4 and 12 nm.

2. Arrangement according to Claim 1,
**characterized in that**
in variant b) the first intermediate layer (22) has the same conduction type as the first conductive layer (21) but has a higher dopant concentration, and the second intermediate layer (23) has the same conduction type as the second conductive layer (24) but has a higher dopant concentration.

## Revendications

1. Arrangement de lasers à diode en semiconducteur empilés les uns sur les autres, comprenant :
- un substrat (1) sur lequel est disposé un premier laser à diode (12) ;
- un deuxième laser à diode (13) qui est disposé sur le premier laser à diode (12) ;
- une couche de contact (6) qui est disposée entre le premier laser à diode (12) et le deuxième laser à diode (13),
la couche de contact (6) possédant une première couche conductrice (18) d'un premier type de conduction, une deuxième couche conductrice (20) d'un deuxième type de conduction et la couche de contact soit
a) comprenant une couche intermédiaire (19) qui est disposée entre les première et deuxième couches conductrices (18, 20) et augmente la probabilité de tunnel pour les porteurs de charge, la couche intermédiaire (19) étant non dopée ou alors la couche intermédiaire (19) est dopée avec le premier type de conduction, mais possède cependant une concentration de matière dopante plus faible que la première couche conductrice (18) du premier type de conduction, soit
b) possèdant une première couche intermédiaire (22) et une deuxième couche intermédiaire (23), les première et deuxième couches intermédiaires (22, 23) étant disposées entre la première et la deuxième couche conductrice (21, 24) et la première couche intermédiaire (22) faisant face à la première couche conductrice (21) et la deuxième couche intermédiaire (23) à la deuxième couche conductrice (24), et les première et deuxième couches intermédiaires (22, 23) possédant une épaisseur entre 4 et 12 nm.

2. Arrangement selon la revendication 1,
**caractérisé en ce que** dans la variante b), la première couche intermédiaire (22) présente le même type de conduction que la première couche conductrice (21), mais possède cependant une concentration de matière dopante plus élevée, et la deuxième couche intermédiaire (23) présente le même type de conduction que la deuxième couche conductrice (24), mais possède cependant une concentration de matière dopante plus élevée.
